(19) Europäisches Patentamt
European Patent Office
Office européen des brevets

(11) **EP 4 261 553 A1**

(12) **EUROPEAN PATENT APPLICATION**
published in accordance with Art. 153(4) EPC

(43) Date of publication:
**18.10.2023 Bulletin 2023/42**

(21) Application number: **22890201.1**

(22) Date of filing: **12.10.2022**

(51) International Patent Classification (IPC):
*G01R 31/389* (2019.01)  *G01R 31/3842* (2019.01)
*G01R 27/02* (2006.01)  *G01R 27/08* (2006.01)
*G01R 31/374* (2019.01)  *G01R 31/396* (2019.01)

(52) Cooperative Patent Classification (CPC):
**G01R 27/02; G01R 27/08; G01R 31/374;
G01R 31/3842; G01R 31/389; G01R 31/396**

(86) International application number:
**PCT/KR2022/015397**

(87) International publication number:
**WO 2023/080466 (11.05.2023 Gazette 2023/19)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: **04.11.2021 KR 20210150560**

(71) Applicant: **LG Energy Solution, Ltd.
Seoul 07335 (KR)**

(72) Inventor: **HONG, Sung Ju
Daejeon 34122 (KR)**

(74) Representative: **Plasseraud IP
66, rue de la Chaussée d'Antin
75440 Paris Cedex 09 (FR)**

(54) **BATTERY MANAGEMENT METHOD, AND BATTERY SYSTEM USING SAME**

(57)   A battery management method included in a method for managing a plurality of battery banks includes: deriving, by a battery management system (BMS), a plurality of bank voltages for the battery banks; calculating, by the BMS, a plurality of first contact resistances that are internal resistance components for each of the battery banks; calculating, by the BMS, a plurality of second contact resistances that are external resistance components for each of the battery banks; calculating, by the BMS, a plurality of contact resistances for each of the battery banks based on the first contact resistances and the second contact resistances; calculating, by the BMS, each of compensation bank voltages obtained by removing a voltage drop component due to a corresponding contact resistance among the contact resistances from each of the bank voltages; and managing, by the BMS, the battery banks based on at least one of the bank voltages and the compensation bank voltages.

FIG. 1

EP 4 261 553 A1

# Description

## [Technical Field]

Cross-Reference to Related Application(s)

This application claims priority to and the benefit of Korean Patent Application No. 10-2021-0150560 filed in the Korean Intellectual Property Office on November 4, 2021, the entire contents of which are incorporated herein by reference.

The present invention relates to a battery management method and a battery system using the same.

## [Background Art]

When a plurality of battery cells are connected in series or in parallel in a battery, a resistance component may occur due to a series-parallel connection of the battery cells or a wiring connection between an external device and the battery.

When the battery cells are connected in parallel so that a battery bank is formed, a voltage of the battery bank has to be measured in order to diagnose the battery bank, to perform balancing between a plurality of battery banks, or to derive a performance of the battery bank. The measured bank voltage may include a voltage generated by the resistance component.

If the battery bank is diagnosed and balancing of the battery bank is performed based on the bank voltage including the voltage generated by the resistance component, an inaccurate result may be derived or battery performance may be affected.

## [Disclosure]

## [Technical Problem]

The present invention is to provide a method in which a bank voltage of each of a plurality of battery banks is calculated in a battery pack including the battery banks and the battery banks are managed based on the bank voltage.

## [Technical Solution]

A battery management method according to one aspect of the present invention relates to a method for managing a plurality of battery banks and includes: deriving, by a battery management system (BMS), a plurality of bank voltages for the battery banks; calculating, by the BMS, a plurality of first contact resistances that are internal resistance components for each of the battery banks; calculating, by the BMS, a plurality of second contact resistances that are external resistance components for each of the battery banks; calculating, by the BMS, a plurality of contact resistances for each of the battery banks based on the first contact resistances and the second contact resistances; calculating, by the BMS, each of compensation bank voltages obtained by removing a voltage drop component due to a corresponding contact resistance among the contact resistances from each of the bank voltages; and managing, by the BMS, the battery banks based on at least one of the bank voltages and the compensation bank voltages.

The calculating of the first contact resistances includes calculating, by the BMS, the first contact resistance of a battery bank for each of the battery banks based on a cell resistance of one of plurality of battery cells that are parallelly connected and are included in the battery bank and an original bank resistance of the battery bank that is a resistance after the battery cells are formed of the battery bank.

The calculating of the first contact resistances further includes calculating, by the BMS, the first contact resistance of the battery bank by subtracting a combined resistance obtained by dividing the cell resistance of one of the battery cells by the number of the battery cells connected in parallel from the original bank resistance of the battery bank.

The calculating of the second contact resistances includes: calculating, by the BMS, a bank resistance based on a bank voltage and a bank current of the battery bank measured in a state in which the battery bank is connected to the BMS; and calculating, by the BMS, the second contact resistance of the battery bank based on the calculated bank resistance and the original bank resistance.

The calculating of the second contact resistances further includes calculating, by the BMS, the second contact resistance of the battery bank by subtracting the original bank resistance from the calculated bank resistance.

The calculating of the contact resistances includes calculating, by the BMS, the contact resistance of the battery bank by adding the first contact resistance to the second contact resistance.

The managing of the battery banks includes: diagnosing, by the BMS, an abnormality of each of the battery banks based on the bank voltages; determining, by the BMS, a battery bank that needs to be discharged among the battery banks based on the compensation bank voltages, and discharging the determined battery bank; and deriving, by the BMS, performances of the battery banks based on at least one of the bank voltages and the compensation bank voltages.

The deriving of the performances of the battery banks includes: estimating, by the BMS, a SOC for each of the battery banks based on each of the compensation bank voltages; estimating, by the BMS, a SOH for each of the battery banks based on each of the compensation bank voltages; and estimating, by the BMS, a SOP for each of the battery banks based on each of the bank voltages.

A battery system according to another aspect of the present invention includes: a battery pack that includes a plurality of battery banks; and a battery management system (BMS) that derives a plurality of bank voltages for the battery banks, respectively calculates a plurality of first contact resistances that are internal resistance components for each of the battery banks and a plurality of second contact resistances that are external resistance components for each of the battery banks, calculates a plurality of contact resistances for each of the battery banks based on the first contact resistances and the second contact resistances, calculates each of compensation bank voltages obtained by removing a voltage drop component due to a corresponding contact resistance among the contact resistances from each of the bank voltages, and manages the battery banks based on at least one of the bank voltages and the compensation bank voltages.

The BMS includes: a bank voltage measurement unit that measures the bank voltages for the battery banks; a contact resistance calculating unit that respectively calculates the first contact resistances that are the internal resistance components for each of the battery banks and the second contact resistances that are the external resistance components for each of the battery banks and that calculates the contact resistances for each of the battery banks based on the first contact resistances and the second contact resistances; and a compensation bank voltage calculation unit that calculates the compensation bank voltage obtained by removing the voltage drop component due to the contact resistance from the bank voltage.

The contact resistance calculating unit calculates the first contact resistance of a battery bank for each of the battery banks based on a cell resistance of one of plurality of battery cells that are included in the battery bank and an original bank resistance of the battery bank that is a resistance after the battery cells are formed of the battery bank, calculates a bank resistance based on a bank voltage and a bank current of the battery bank measured in a state in which the battery bank is connected to the BMS, calculates the second contact resistance of the battery bank based on the calculated bank resistance and the original bank resistance, and calculates the contact resistance of the battery bank by adding the first contact resistance to the second contact resistance.

The BMS further includes: an abnormality diagnosis unit that diagnoses an abnormality of each of the battery banks based on the bank voltages; a balancing unit that determines a battery bank that needs to be discharged among the battery banks based on the compensation bank voltages and discharges the determined battery bank; and a battery performance deriving unit that estimates a SOC, a SOH, and a SOP of the battery banks based on at least one of the bank voltages and the compensation bank voltages.

The battery performance deriving unit estimates the SOC for each of the battery banks based on each of the compensation bank voltages, estimates the SOH for each of the battery banks based on each of the compensation bank voltages, and estimates the SOP for each of the battery banks based on each of the bank voltages.

[Advantageous Effects]

The present disclosure may provide a battery management method in which a bank voltage of each of a plurality of battery banks is calculated in a battery pack including the battery banks and abnormal detection, balancing, battery performance deriving, or the like for the battery banks is managed based on the bank voltage, and a battery system using the battery management method.

[Brief Description of the Drawings]

FIG. 1 is a view illustrating a battery system according to an embodiment.
FIG. 2 is a block diagram schematically illustrating a configuration of a battery management system.
FIG. 3 is a flowchart illustrating a battery management method according to an embodiment.
FIG. 4 is a detailed flowchart illustrating a step of calculating a contact resistance.

[Modes of Practice]

Hereinafter, embodiments disclosed in the present specification will be described in detail with reference to the accompanying drawings, and in the present specification, the same or similar constituent elements will be denoted by the same or similar reference numerals, and a redundant description thereof will be omitted. The terms "module" and/or "unit, portion, or part" representing constituent element used in the following description are used only in order to make understanding of the specification easier, and thus, these terms do not have meanings or roles that distinguish them from each other by themselves. In addition, in describing embodiments of the present specification, when it is determined that a detailed description of the well-known art associated with the present invention may obscure the gist of the present invention, it will be omitted. Further, the accompanying drawings are provided only in order to allow embodiments disclosed in the present specification to be easily understood and are not to be interpreted as limiting the spirit disclosed in the present specification, and it is to be understood that the present invention includes all modifications, equivalents, and substitutions without departing from the scope and spirit of the present invention.

Terms including ordinal numbers such as first, second, and the like will be used only to describe various constituent elements, and are not to be interpreted as limiting these constituent elements. The terms are only used to differentiate one constituent element from other constituent elements.

In the present application, it should be understood that the term "include", "comprise", "have", or "configure" indicates that a feature, a number, a step, an operation, a constituent element, a part, or a combination thereof described in the specification is present, but does not exclude a possibility of presence or addition of one or more other features, numbers, steps, operations, constituent elements, parts, or combinations, in advance.

From among configurations according to an embodiment, a program that is realized with a set of instructions that are an actualized control algorithm for controlling other configurations may be installed in the configuration for controlling the other configurations in a specific control condition. A control configuration may process input data and stored data according to the installed program and may generate output data. The control configuration may include a non-volatile memory for storing a program and a memory for storing data.

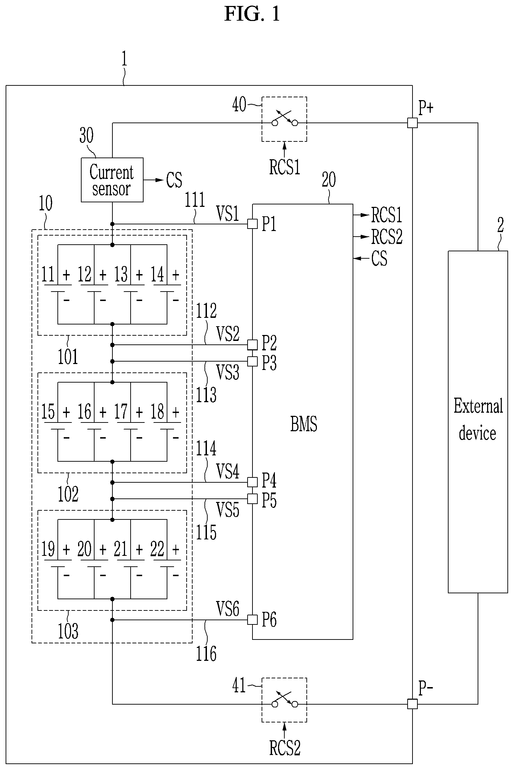

FIG. 1 is a view illustrating a battery system according to an embodiment.

The battery system 1 includes a battery pack 10, a battery management system 20, a current sensor 30, and relays 40 and 41. Hereinafter, the battery management system 20 is referred to as a BMS. In FIG. 1, the number of the battery pack 10 is illustrated as one, but the present invention is not limited thereto, and the battery system 1 may include two or more battery packs.

An external device 2 may include a load (e.g., an inverter, a converter, or the like) and a charging device. When the external device 2 is a charger, both ends of the battery system 1 may be connected to the charger so that the battery system receives electric power from the charger to be charged. When the external device 2 is the load, both ends of the battery system 1 may be connected to the load so that power supplied by the battery pack 10 is discharged through the load.

The battery pack 10 includes a plurality of battery banks 101-103 connected in series. In FIG. 1, the number of the battery banks is illustrated as three, but the invention is not limited thereto, and the battery pack 10 may include two or more battery banks.

Each (e.g., 101) of the battery banks 101-103 includes a plurality of battery cells (e.g., 11-14) connected in parallel. Although FIG. 1 illustrates that each battery bank (for example, 101) includes four battery cells (for example, 11-14) connected in parallel, the present invention is not limited thereto, and each battery bank may include two or more battery cells connected in parallel.

The BMS 20 may calculate a contact resistance of each of the battery banks 101-103 based on a cell resistance of each of the battery cells 11-22, an original bank resistance of each of the battery banks 101-103 measured before the battery pack 10 is connected to the BMS 20, and each bank resistance of the battery banks 101-103 that is a resistance after the battery pack 10 is connected to the BMS 20. The BMS 20 may measure a bank voltage of each of the battery banks 101-103, and may derive a compensation bank voltage obtained by subtracting a drop voltage due to the contact resistance from the measured bank voltage. The BMS 20 may manage the battery banks 101-103 using the bank voltage and the compensation bank voltage. Management of the battery banks may include abnormality diagnosis, balancing, state of charge (SOC) estimation, state of health (SOH) estimation, and state of power (SOP) estimation for the battery bank.

The BMS 20 may be connected to the battery banks 101-103 through a plurality of wirings 111-116, and each voltage VS1, VS2, VS3, VS4, VS5, or VS6 of both ends of the battery banks 101-103 may be measured through a plurality of terminals P1-P6. For example, a positive electrode of the battery bank 101 may be connected to a terminal P1 through wiring 111, and the BMS 20 may measure a positive voltage VS1 of the battery bank 101 through the terminal P1. A negative electrode of the battery bank 101 may be connected to a terminal P2 through wiring 112, and the BMS 20 may measure a negative voltage VS2 of the battery bank 101 through the terminal P2. The BMS 20 obtains a current measurement signal CS from the current sensor 30. The BMS 20 may derive a bank current flowing through the battery banks 101-103 from the current measurement signal CS.

The current sensor 30 may measure a current flowing through the battery banks 101-103. For example, the current sensor 30 may be implemented as a Hall sensor, and the current sensor 30 may be positioned to sense the bank current of the battery banks 101-103.

One ends of the relays 40 and 41 are connected to positive and negative electrodes of the battery pack 10, and the other ends of the relays 40 and 41 are connected to at least one component of the external device 2. Closing and opening of the relays 40 and 41 are controlled according to relay control signals RCS1 and RCS2 supplied from the BMS 20.

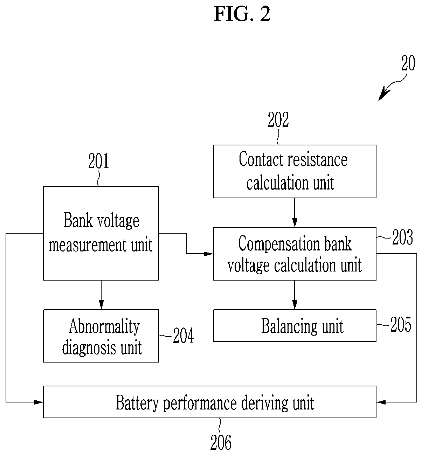

FIG. 2 is a block diagram schematically illustrating a configuration of a battery management system.

The BMS 20 may include a bank voltage measurement unit (or a bank voltage measurement device) 201, a contact resistance calculation unit (or a contact resistance calculator) 202, a compensation bank voltage calculation unit 203, an abnormality diagnosis unit 204, a balancing unit 205, and a battery performance deriving unit 206.

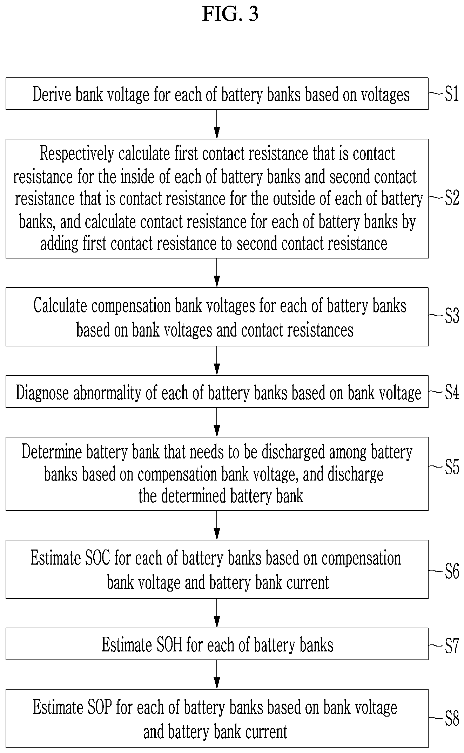

Hereinafter, an operation of each configuration of the BMS 20 for managing each of the battery banks 101-103 will be sequentially described according to a flowchart shown in FIG. 3.

FIG. 3 is a flowchart illustrating a battery management method according to an embodiment.

The bank voltage measurement unit 201 derives a bank voltage of each of the battery banks 101-103 based on the plurality of voltages VS1-VS6 (S1).

The bank voltage measurement unit 201 may derive the bank voltage of each of the battery banks 101-103 from the voltages VS1-VS6. For example, the bank voltage measurement unit 201 may derive a bank voltage of the battery bank 101 based on a voltage difference between the voltage VS1 and the voltage VS2.

The contact resistance calculation unit 202 may respectively calculate a first contact resistance that is a contact resistance of the inside of each of the battery banks 101-103 and a second contact resistance that is a contact resistance of the outside of each of the battery banks 101-103, and may calculate a contact resistance for each of the battery banks 101-103 by adding the first contact resistance to the second contact resistance (S2).

The first contact resistance may be a resistance of a conductive member (hereinafter referred to as an electrical member) or the like such as wiring provided to electrically connect the battery cells (e.g., 11-14) in a configuration in which the battery cells 11-14 are electrically connected in parallel so that the battery bank (e.g., 101) is formed. The first contact resistance may include a resistance component mainly originating from the inside of the battery bank.

The second contact resistance may be a resistance of a conductive member or the like such as wiring provided to electrically connect each of the battery banks 101-103 to the terminals P1-P6 of the BMS 20 so that the battery banks 101-103 are connected to the BMS 20. The second contact resistance may include a resistance component mainly originating from the outside of the battery bank.

The contact resistance calculation unit 202 calculates the first contact resistance for each of the battery banks 101-103 based on a cell resistance for each of the battery cells 11-22 and an original bank resistance of each of the battery banks 101-103 measured before each of the battery banks 101-103 is connected to the BMS 20. The contact resistance calculation unit 202 calculates a bank resistance of each of the battery banks 101-103 based on a bank voltage and a battery bank current of each of the battery banks 101-103 in a state in which each of the battery banks 101-103 is connected to the BMS 20, and calculates the second contact resistance for each of the battery banks 101-103 based on the bank resistance and the original bank resistance. The contact resistance calculation unit 202 may calculate a contact resistance for each of the battery banks 101-103 by adding the first contact resistance of each of the battery banks 101-103 to the second contact resistance of each of the battery banks.

The cell resistance is a battery cell unit resistance of each of the battery cells 11-22. The battery cell unit resistance may be measured based on a voltage applied to both ends of the battery cell and a current flowing through the battery cell when the battery cell is not connected to another configuration. With regard to the cell resistance, each of the battery cells 11-22 included in the battery pack 10 may have the same value.

The original bank resistance is a battery bank unit resistance for each of the battery banks 101-103 after four battery cells 11-14 are electrically connected in parallel so that the battery banks 101-103 are formed. The battery bank unit resistance may be measured based on a voltage applied to both ends of the battery bank and a current flowing through the battery bank when the battery banks 101-103 are not connected to another device. The original bank resistance for each of the battery banks 101-103 included in the battery pack 10 may be measured.

The bank resistance may be calculated based on a bank voltage and a battery bank current of each of the battery banks 101-103 in a state in which each of the battery banks 101-103 is connected to the BMS 20.

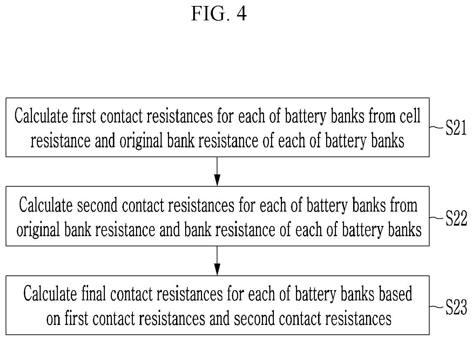

Hereinafter, a process in which the contact resistance calculation unit 202 calculates the contact resistance for each of the battery banks 101-103 based on the cell resistance, the original bank resistance, and the bank resistance will be described with reference to FIG. 4.

FIG. 4 is a detailed flowchart illustrating a step of calculating the contact resistance.

The contact resistance calculation unit 202 may calculate a plurality of first contact resistances for each of the battery banks 101-103 from the cell resistance, and the original bank resistance of each of the battery banks 101-103 (S21).

Referring to Equation 1, the first contact resistances may be calculated based on the cell resistance and the original bank resistance.

$$\text{(Equation 1)}$$

$$R_{1.k} = R_{o\_bank.k} - R_{cell}/n$$

R1.k is a first contact resistance ($\Omega$) of a kth battery bank. k is an index indicating each battery bank, and may be a natural number of 1 or more and m or less. m may be the total number of a plurality of battery banks included in the battery pack 10. n is the number of parallel-connected battery cells in the battery bank. $R_{o\_bank.k}$ is an original bank resistance ($\Omega$) of the kth battery bank. $R_{cell}$ is the cell resistance ($\Omega$).

In an example of FIG. 1, the total number (m) of the battery banks is 3, and the number (n) of battery cells connected in parallel is 4.

Since four battery cells 11-14 are connected in parallel in each of the battery banks 101, the contact resistance calculation unit 202 may be calculated by subtracting a combined resistance ($R_{cell}/4$) of the battery cells 11-14 from the original bank resistance of the battery bank 101. The first contact resistance for each of the battery banks 102 and 103 may also be calculated in the same manner as above.

The contact resistance calculation unit 202 may calculate a plurality of second contact resistances for each of the battery banks 101-103 from the original bank resistance and the bank resistance of each of the battery banks 101-103 (S22).

Referring to Equation 2, the second contact resistances may be calculated based on the original bank resistance and the bank resistance of each of the battery banks 101 to 103.

## (Equation 2)

$$R_{2.k} = R_{bank.k} - R_{o\_bank.k}$$

$R_{2.k}$ is a second contact resistance ($\Omega$) of a kth battery bank. k is an index indicating each battery bank, and may be a natural number of 1 or more and m or less. m may be the total number of a plurality of battery banks included in the battery pack 10. n is the number of parallel-connected battery cells in the battery bank. $R_{bank.k}$ is a bank resistance ($\Omega$) of the kth battery bank. $R_{0\_bank.k}$ is an original bank resistance ($\Omega$) of the kth battery bank.

The contact resistance calculation unit 202 may calculate a plurality of final contact resistances for each of the battery banks 101-103 based on the first contact resistances and the second contact resistances (S23).

Referring to Equation 3, the final contact resistances may be calculated based on the first contact resistances and the second contact resistances.

## (Equation 3)

$$R_{total.k} = R_{1.k} + R_{2.k}$$

$R_{total.k}$ is a final contact resistance [$\Omega$] of a kth battery bank. k is an index indicating each battery bank, and may be a natural number of 1 or more and m or less. m may be the total number of a plurality of battery banks included in the battery pack 10. n is the number of parallel-connected battery cells in the battery bank. $R_{1.k}$ is a first contact resistance ($\Omega$) of the kth battery bank. $R_{2.k}$ is a second contact resistance ($\Omega$) of the kth battery bank.

Hereinafter, it will be described that the final contact resistance derived in the step S23 is the contact resistance of the step S2.

When the contact resistance calculating unit 202 calculates contact resistances of each of the battery banks 101-103, the compensation bank voltage calculation unit 203 calculates a plurality of compensation bank voltages for each of the battery banks 101-103 based on the bank voltages and the contact resistances (S3).

The compensation bank voltage may represent a voltage obtained by removing a voltage drop component due to the contact resistance from the bank voltage of each of the battery banks 101-103.

Referring to Equation 4, the compensation bank voltages may be calculated based on the bank voltages and the contact resistances.

## (Equation 4)

$$V_{c.bank.k} = VB_k - IB * R_{total.k}$$

$V_{c.bank.k}$ is a compensation bank voltage (V) of a kth battery bank. k is an index indicating each battery bank, and may be a natural number of 1 or more and m or less. m may be the total number of a plurality of battery banks included in the battery pack 10. n is the number of parallel-connected battery cells in the battery bank. $VB_k$ is a bank voltage (V) of the kth battery bank. IB is a bank current (A) of the battery banks 101-103. $R_{total.k}$ is a contact resistance ($\Omega$) of the kth battery bank.

Hereinafter, a process in which the abnormality diagnosis unit 204 manages the battery banks 101-103 by deriving abnormality diagnosis, balancing, and battery performance (SOC, SOH, and SOP) for the battery banks 101-103 based on at least one of the bank voltage for each of the battery banks 101-103 measured by the bank voltage measurement unit 201 and the compensation bank voltage for each of the battery banks calculated by the compensation bank voltage calculation unit 203 will be described.

The abnormality diagnosis unit 204 diagnoses an abnormality of each of the battery banks 101-103 based on the bank voltage (S4).

For example, the abnormality diagnosis unit 204 may compare the bank voltage of each of the battery banks 101-103 with a predetermined reference voltage to diagnose whether the battery cells included in the battery bank are in an overvoltage state or a low voltage state.

The balancing unit 205 may determine a battery bank that needs to be discharged among the battery banks 101-103 based on the compensation bank voltage, and may discharge the determined battery bank (S5).

The balancing described in the present specification may refer to a charge equalization operation for a battery bank having the compensation bank voltage equal to or greater than a predetermined reference value among the battery banks 101-103 included in the battery pack 10. The reference value may be a value set based on the compensation bank voltages of the battery banks 101-103, and may be a representative value for the compensation bank voltages. The representative value may be an average value, an intermediate value, a minimum value, or the like.

The balancing unit 205 may discharge the determined battery bank by a discharging load (not shown) connected in parallel with the battery bank.

Hereinafter, a step in which the battery performance deriving unit 206 estimates a state of charge (SOC), a state of health (SOH), a state of power (SOP), and the like based on at least one of the compensation bank voltage and the bank voltage so that battery performance is derived will be described.

The battery performance deriving unit 206 estimates the SOC of each of the battery banks 101-103 based on the compensation bank voltage and the battery bank current (S6).

The SOC for a battery may indicate a remaining capacity charged in the battery and may be used as one of indicators indicating a performance of the battery.

The battery performance deriving unit 206 may use a modeling method for estimating the SOC by applying the compensation bank voltage to a bank model circuit, or may use a modeling method and a current integration method for integrating the battery bank current. The bank model circuit may be obtained by modeling the battery bank as an equivalent circuit. When the battery performance deriving unit 206 uses both the modeling method and the current integration method, a weight for the SOC estimated by each method may be adjusted in consideration of a current state of the battery bank. In addition, one of various known methods may be used for SOC estimation.

The battery performance deriving unit 206 estimates the SOH for each of the battery banks 101-103 (S7).

The SOH for a battery may indicate a degree of deterioration or a remaining life of the battery, and may be used as one of indicators indicating performance of the battery.

The battery performance deriving unit 206 may estimate the SOH based on the SOC of each of the battery banks 101-103, or may estimate the SOH based on an internal resistance of each of the battery banks 101-103. The battery performance deriving unit 206 may derive the internal resistance based on the compensation bank voltage and the battery bank current. In addition, one of various known methods may be applied to a method of estimating the SOH.

The battery performance deriving unit 206 estimates the SOP for each of the battery banks 101-103 based on the bank voltage and the battery bank current (S8).

The SOP for a battery may indicate an available output charged in the battery and may be used as one of indicators indicating performance of the battery. A method of estimating the SOP for the battery bank may use various known methods.

The battery performance deriving unit 206 may derive the SOP for the battery pack 10 based on the SOP for each of the battery banks 101-103.

The battery performance deriving unit 206 may evaluate performance of each of the battery banks 101-103 based on the SOC, the SOH, and the SOP estimated for each of the battery banks 101-103. In addition, the battery performance deriving unit 206 may evaluate a performance of the battery pack 10 based on the performance evaluated for each battery bank.

As described above, one of various known methods may be applied to a method of estimating the SOC, the SOH, and the SOP. When the voltage of the battery bank is used in the method, the compensation bank voltage may be used for the SOC estimation and the SOH estimation, and the bank voltage may be used for SOP estimation.

While this invention has been described in connection with what is presently considered to be practical embodiments, it is to be understood that the invention is not limited to the disclosed embodiments, but, on the contrary, is intended to cover various modifications and equivalent arrangements included within the spirit and scope of the appended claims.

**Claims**

1. A battery management method included in a method for managing a plurality of battery banks, comprising:

   deriving, by a battery management system (BMS), a plurality of bank voltages of the plurality of battery banks;
   calculating, by the BMS, a plurality of first contact resistances that are internal resistance components for each of the battery banks;
   calculating, by the BMS, a plurality of second contact resistances that are external resistance components for each of the battery banks;
   calculating, by the BMS, a plurality of contact resistances for each of the battery banks based on the first contact resistances and the second contact resistances;
   calculating, by the BMS, each of compensation bank voltages obtained by removing a voltage drop component due to a corresponding contact resistance among the contact resistances from each of the bank voltages; and
   managing, by the BMS, the battery banks based on at least one of the bank voltages and the compensation bank voltages.

2. The battery management method of claim 1, wherein the calculating of the first contact resistances comprises
   calculating, by the BMS, the first contact resistance of a battery bank for each of the battery banks based on a cell resistance of one of plurality of battery cells that are parallelly connected and are included in the battery bank and an original bank resistance of the battery bank that is a resistance after the battery cells are formed of the battery bank.

3. The battery management method of claim 2, wherein the calculating of the first contact resistances further comprises
   calculating, by the BMS, the first contact resistance of the battery bank by subtracting a combined resistance obtained by dividing the cell resistance of one of the battery cells by the number of the battery cells connected in parallel from the original bank resistance of the battery bank.

4. The battery management method of claim 2, wherein the calculating of the second contact resistances comprises:

   calculating, by the BMS, a bank resistance based on a bank voltage and a bank current of the battery bank measured in a state in which the battery bank is connected to the BMS; and calculating, by the BMS, the second contact resistance of the battery bank based on the calculated bank resistance and the original bank resistance.

5. The battery management method of claim 4, wherein the calculating of the second contact resistances further comprises
   calculating, by the BMS, the second contact resistance of the battery bank by subtracting the original bank resistance from the calculated bank resistance.

6. The battery management method of claim 4, wherein the calculating of the contact resistances comprises
   calculating, by the BMS, the contact resistance of the battery bank by adding the first contact resistance to the second contact resistance.

7. The battery management method of claim 1, wherein the managing of the battery banks comprises:

   diagnosing, by the BMS, an abnormality of each of the battery banks based on the bank voltages; determining, by the BMS, a battery bank that needs to be discharged among the battery banks based on the compensation bank voltages, and discharging the determined battery bank; and deriving, by the BMS, performances of the battery banks based on at least one of the bank voltages and the compensation bank voltages.

8. The battery management method of claim 7, wherein the deriving of the performances of the battery banks comprises:

   estimating, by the BMS, a SOC for each of the battery banks based on each of the compensation bank voltages; estimating, by the BMS, a SOH for each of the battery banks based on each of the compensation bank voltages; and estimating, by the BMS, a SOP for each of the battery banks based on each of the bank voltages.

9. A battery system comprising:

a battery pack that includes a plurality of battery banks; and
a battery management system (BMS) that derives a plurality of bank voltages for the battery banks, respectively calculates a plurality of first contact resistances that are internal resistance components for each of the battery banks and a plurality of second contact resistances that are external resistance components for each of the battery banks, calculates a plurality of contact resistances for each of the battery banks based on the first contact resistances and the second contact resistances, calculates each of compensation bank voltages obtained by removing a voltage drop component due to a corresponding contact resistance among the contact resistances from each of the bank voltages, and manages the battery banks based on at least one of the bank voltages and the compensation bank voltages.

10. The battery system of claim 9, wherein the BMS comprises:

   a bank voltage measurement unit that measures the bank voltages for the battery banks; a contact resistance calculating unit that respectively calculates the first contact resistances that are the internal resistance components for each of the battery banks and the second contact resistances that are the external resistance components for each of the battery banks and that calculates the contact resistances for each of the battery banks based on the first contact resistances and the second contact resistances; and a compensation bank voltage calculation unit that calculates the compensation bank voltage obtained by removing the voltage drop component due to the contact resistance from the bank voltage.

11. The battery system of claim 10, wherein the contact resistance calculating unit calculates the first contact resistance of a battery bank for each of the battery banks based on a cell resistance of one of plurality of battery cells that are included in the battery bank and an original bank resistance of the battery bank that is a resistance after the battery cells are formed of the battery bank, calculates a bank resistance based on a bank voltage and a bank current of the battery bank measured in a state in which the battery bank is connected to the BMS, calculates the second contact resistance of the battery bank based on the calculated bank resistance and the original bank resistance, and calculates the contact resistance of the battery bank by adding the first contact resistance to the second contact resistance.

**12.** The battery system of claim 10, wherein the BMS further comprises:

> an abnormality diagnosis unit that diagnoses an abnormality of each of the battery banks based on the bank voltages;
> a balancing unit that determines a battery bank that needs to be discharged among the battery banks based on the compensation bank voltages and discharges the determined battery bank; and
> a battery performance deriving unit that estimates a SOC, a SOH, and a SOP of the battery banks based on at least one of the bank voltages and the compensation bank voltages.

**13.** The battery system of claim 12, wherein the battery performance deriving unit estimates the SOC for each of the battery banks based on each of the compensation bank voltages, estimates the SOH for each of the battery banks based on each of the compensation bank voltages, and estimates the SOP for each of the battery banks based on each of the bank voltages.

# FIG. 1

FIG. 2

## FIG. 3

| |
|---|
| Derive bank voltage for each of battery banks based on voltages |

~S1

| |
|---|
| Respectively calculate first contact resistance that is contact resistance for the inside of each of battery banks and second contact resistance that is contact resistance for the outside of each of battery banks, and calculate contact resistance for each of battery banks by adding first contact resistance to second contact resistance |

~S2

| |
|---|
| Calculate compensation bank voltages for each of battery banks based on bank voltages and contact resistances |

~S3

| |
|---|
| Diagnose abnormality of each of battery banks based on bank voltage |

~S4

| |
|---|
| Determine battery bank that needs to be discharged among battery banks based on compensation bank voltage, and discharge the determined battery bank |

~S5

| |
|---|
| Estimate SOC for each of battery banks based on compensation bank voltage and battery bank current |

~S6

| |
|---|
| Estimate SOH for each of battery banks |

~S7

| |
|---|
| Estimate SOP for each of battery banks based on bank voltage and battery bank current |

~S8

FIG. 4

| Calculate first contact resistances for each of battery banks from cell resistance and original bank resistance of each of battery banks | ~S21 |

↓

| Calculate second contact resistances for each of battery banks from original bank resistance and bank resistance of each of battery banks | ~S22 |

↓

| Calculate final contact resistances for each of battery banks based on first contact resistances and second contact resistances | ~S23 |

# EP 4 261 553 A1

| INTERNATIONAL SEARCH REPORT | International application No. |
|---|---|
| | **PCT/KR2022/015397** |

**A.    CLASSIFICATION OF SUBJECT MATTER**

**G01R 31/389**(2019.01)i; **G01R 31/3842**(2019.01)i; **G01R 27/02**(2006.01)i; **G01R 27/08**(2006.01)i; **G01R 31/374**(2019.01)i; **G01R 31/396**(2019.01)i

According to International Patent Classification (IPC) or to both national classification and IPC

**B.    FIELDS SEARCHED**

Minimum documentation searched (classification system followed by classification symbols)

G01R 31/389(2019.01); G01R 31/36(2006.01); G01R 31/396(2019.01); H01M 10/44(2006.01); H01M 10/48(2006.01); H02J 7/04(2006.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 배터리 뱅크(battery bank), 관리(management), BMS(battery management system), 접촉 저항(contact resistance), 보상 뱅크 전압(compensation bank voltage)

**C.    DOCUMENTS CONSIDERED TO BE RELEVANT**

| Category* | Citation of document, with indication, where appropriate, of the relevant passages | Relevant to claim No. |
|---|---|---|
| A | KR 10-2014-0081309 A (NEXCON TEC CO., LTD.) 01 July 2014 (2014-07-01)<br>See paragraphs [0035]-[0042] and figures 1-2. | 1-13 |
| A | KR 10-2021-0011236 A (LG CHEM, LTD.) 01 February 2021 (2021-02-01)<br>See paragraph [0045] and figures 2 and 4. | 1-13 |
| A | KR 10-2013-0100523 A (SK INNOVATION CO., LTD.) 11 September 2013 (2013-09-11)<br>See claims 1-10 and figures 1-2. | 1-13 |
| A | KR 10-2015-0037406 A (LG CHEM, LTD.) 08 April 2015 (2015-04-08)<br>See claims 1-12 and figures 1-5. | 1-13 |
| A | KR 10-2019-0035441 A (POSCO ICT COMPANY LTD) 03 April 2019 (2019-04-03)<br>See paragraphs [0085]-[0092] and figures 3 and 9. | 1-13 |

| ☐ Further documents are listed in the continuation of Box C. | ☑ See patent family annex. |
|---|---|

\*    Special categories of cited documents:
"A"    document defining the general state of the art which is not considered to be of particular relevance
"D"    document cited by the applicant in the international application
"E"    earlier application or patent but published on or after the international filing date
"L"    document which may throw doubts on priority claim(s) or which is cited to establish the publication date of another citation or other special reason (as specified)
"O"    document referring to an oral disclosure, use, exhibition or other means
"P"    document published prior to the international filing date but later than the priority date claimed

"T"    later document published after the international filing date or priority date and not in conflict with the application but cited to understand the principle or theory underlying the invention
"X"    document of particular relevance; the claimed invention cannot be considered novel or cannot be considered to involve an inventive step when the document is taken alone
"Y"    document of particular relevance; the claimed invention cannot be considered to involve an inventive step when the document is combined with one or more other such documents, such combination being obvious to a person skilled in the art
"&"    document member of the same patent family

| Date of the actual completion of the international search | Date of mailing of the international search report |
|---|---|
| **12 January 2023** | **12 January 2023** |

| Name and mailing address of the ISA/KR | Authorized officer |
|---|---|
| **Korean Intellectual Property Office**<br>**Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2022)

**INTERNATIONAL SEARCH REPORT**
**Information on patent family members**

International application No.

**PCT/KR2022/015397**

| Patent document cited in search report | | | Publication date (day/month/year) | Patent family member(s) | | | Publication date (day/month/year) |
|---|---|---|---|---|---|---|---|
| KR | 10-2014-0081309 | A | 01 July 2014 | None | | | |
| KR | 10-2021-0011236 | A | 01 February 2021 | CN | 113711068 | A | 26 November 2021 |
| | | | | EP | 3940404 | A1 | 19 January 2022 |
| | | | | EP | 3940404 | A4 | 20 April 2022 |
| | | | | JP | 2022-521923 | A | 13 April 2022 |
| | | | | US | 2022-0155378 | A1 | 19 May 2022 |
| | | | | WO | 2021-015501 | A1 | 28 January 2021 |
| KR | 10-2013-0100523 | A | 11 September 2013 | KR | 10-2039954 | B1 | 05 November 2019 |
| KR | 10-2015-0037406 | A | 08 April 2015 | KR | 10-1642329 | B1 | 25 July 2016 |
| KR | 10-2019-0035441 | A | 03 April 2019 | KR | 10-1989692 | B1 | 14 June 2019 |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- KR 1020210150560